# DEMANDE DE BREVET EUROPEEN

(11) **EP 3 171 419 A1**
(43) Date de publication de la demande: **24.05.2017**
(21) Numéro de dépôt: 16197981.0
(22) Date de dépôt: 09.11.2016
(51) Int. Cl.: H01L 51/05, H01L 41/45, H01L 41/193, C08F 214/22

(54) **DISPOSITIF ÉLECTRONIQUE ET SON PROCÉDÉ DE FABRICATION**

(30) Priorité: 17.11.2015 FR 1561045
(71) Demandeur: COMMISSARIAT À L'ÉNERGIE ATOMIQUE ET AUX ÉNERGIES ALTERNATIVES, 75015 Paris (FR)
(72) Inventeur: ALIANE, Abdelkader, 38100 GRENOBLE (FR); BENWADIH, Mohammed, 94500 CHAMPIGNY-SUR-MARNE (FR)
(74) Mandataire: Thibon, Laurent

(57) **Abrégé**

L'invention concerne un procédé de fabrication d'un dispositif électronique (30) comprenant un film (32) comprenant les étapes suivantes :
former au moins d'une couche d'une solution comprenant un solvant et un composé comprenant un polymère choisi parmi le groupe comprenant le poly(fluorure de vinylidène - trifluoroéthylène - chlorofluoroéthylène) (P(VDF-TrFE-CFE)), le poly(fluorure de vinylidène - trifluoroéthylène - chlorotrifluoro éthylène) (P(VDF-TrFE-CTFE)) et un mélange de ces composés, le taux de chlore en molécules du copolymère étant supérieur ou égal à 3 % ; et
irradier au moins la couche avec des impulsions d'au moins un rayonnement ultraviolet.

## Description

### Domaine

La présente demande concerne un procédé de fabrication d'un dispositif électronique comprenant un film d'un copolymère de polyfluorure de vinylidène (PVDF) et un dispositif électronique obtenu par un tel procédé.

### Exposé de l'art antérieur

Il est connu de réaliser un dispositif électronique comprenant un film d'un copolymère du PVDF. Selon un exemple, le dispositif électronique correspond à un transistor à effet de champ à grille métal-oxyde, également appelé transistor MOS, le film du copolymère de PVDF formant l'isolant de grille du transistor. Selon un autre exemple, le dispositif électronique correspond à un dispositif pyroélectrique et/ou piézoélectrique pouvant être utilisé comme capteur, par exemple comme capteur de pression, comme interrupteur ou comme dispositif de récupération d'énergie.

Les copolymères de PVDF sont des polymères semi-cristallins, qui après l'étape de polymérisation, ont un taux de cristallinité volumique généralement comprise entre 45 % et 55 %. Le copolymère de PVDF peut comprendre des phases cristallines de trois types α, β et γ. Après l'étape de polymérisation, la phase cristalline obtenue est généralement en majorité la phase α. Les propriétés d'isolation électrique du film obtenu ne sont généralement pas adaptées à une utilisation comme isolant de grille d'un transistor MOS. De plus, la phase β peut présenter des propriétés pyroélectriques et piézoélectriques tandis que la phase α n'en présente pas. De ce fait, le film obtenu après polymérisation n'est pas adapté à une utilisation dans un dispositif pyroélectrique et/ou piézoélectrique.

Un traitement supplémentaire doit alors généralement être prévu pour transformer au moins en partie la phase α en phase β, ce qui permet d'obtenir les propriétés d'isolation électrique, les propriétés pyroélectriques et/ou les propriétés piézoélectriques souhaitées. Le traitement peut, en outre, entraîner une augmentation du taux de cristallinité du film.

Ce traitement peut comprendre :
un recuit thermique, par exemple à une température comprise entre 110°C et 170°C pendant une durée variant de plusieurs minutes à plusieurs heures ;
l'application au film d'un champ électrique d'intensité élevée pendant plusieurs heures ; et/ou
l'ionisation de l'air autour du film du copolymère de PVDF.

Il peut être souhaitable de former le film du copolymère de PVDF sur un substrat d'un matériau plastique, par exemple du polyéthylène naphtalate (PEN) ou du polyéthylène téréphtalate (PET). Il peut, en outre, être souhaitable de former le film du copolymère de PVDF sur un substrat sur lequel ou dans lequel sont également réalisés d'autres composants électroniques.

Un inconvénient des traitements décrits précédemment est qu'ils peuvent ne pas être compatibles avec l'utilisation d'un substrat plastique ou avec la formation de composants électroniques, notamment en raison des températures élevées et/ou des contraintes mécaniques appliquées. Un autre inconvénient des traitements d'étirement mécanique du polymère, d'application d'un champ électrique ou d'ionisation de l'air est qu'ils peuvent être complexes à mettre en oeuvre, notamment à une échelle industrielle. Un autre inconvénient des traitements de recuit thermique et d'application d'un champ électrique est qu'ils peuvent avoir une durée importante.

### Résumé

Un mode de réalisation vise à pallier les inconvénients des procédés de fabrication des dispositifs électroniques décrits précédemment.

Un autre mode de réalisation vise la fabrication d'un dispositif électronique comprenant un film d'un copolymère de PVDF sur un substrat plastique.

Un autre mode de réalisation vise la fabrication d'un dispositif électronique comprenant un film d'un copolymère de PVDF sur un substrat sur lequel ou dans lequel sont également formés d'autres composants électroniques.

Un autre mode de réalisation vise à réduire la durée du procédé de fabrication d'un dispositif électronique comprenant un film d'un copolymère de PVDF.

Un autre mode de réalisation vise un procédé de fabrication pouvant être mis en oeuvre à une échelle industrielle.

Ainsi, un mode de réalisation prévoit un procédé de fabrication d'un dispositif électronique comprenant un film comprenant les étapes suivantes :
former au moins d'une couche d'une solution comprenant un solvant et un composé comprenant un polymère choisi parmi le groupe comprenant le poly(fluorure de vinylidène - trifluoroéthylène - chlorofluoroéthylène), le poly(fluorure de vinylidène - trifluoroéthylène - chlorotrifluoro éthylène) et un mélange de ces composés, le taux de chlore en molécules du copolymère étant supérieur ou égal à 3 % ; et
irradier au moins la couche avec des impulsions d'au moins un rayonnement ultraviolet.

Selon un mode de réalisation, le rayonnement ultraviolet est émis par une source, ladite couche comprenant une face exposée au rayonnement ultraviolet et la distance entre ladite face et la source est comprise entre 2 cm et 10 cm.

Selon un mode de réalisation, la durée de chaque impulsion est comprise entre 500 µs et 2 ms.

Selon un mode de réalisation, la fluence en énergie du rayonnement ultraviolet est comprise entre 10 J/cm² et 25 J/cm².

Selon un mode de réalisation, seule une partie de la couche est chauffée au cours de l'étape d'irradiation.

Selon un mode de réalisation, l'étape d'irradiation est suivie d'une étape de recuit thermique du reste de la couche à une température comprise entre 80°C et 120°C.

Selon un mode de réalisation, le solvant a une température d'évaporation comprise entre 110°C et 140°C.

Selon un mode de réalisation, la solution comprend de 80 % à 95 % en poids du solvant et de 5 % à 20 % en poids du composé.

Selon un mode de réalisation, le solvant est adapté à absorber au moins partiellement le rayonnement ultraviolet.

Selon un mode de réalisation, le composé comprend, en outre, des particules en céramique.

Un mode de réalisation prévoit également un dispositif piézoélectrique et/ou pyroélectrique comprenant une couche comprenant en majorité un polymère en partie cristallisé choisi parmi le groupe comprenant le poly(fluorure de vinylidène - trifluoroéthylène - chlorofluoroéthylène), le poly(fluorure de vinylidène - trifluoroéthylène - chlorotrifluoro éthylène) et un mélange de ces composés, le taux de chlore en molécules du copolymère étant supérieur ou égal à 3 %, dans lequel sur au moins une partie de l'épaisseur de la couche, la phase cristalline ou les phases cristallines du polymère ont la même orientation cristallographique.

Selon un mode de réalisation, la couche comprend une première sous-couche dudit polymère cristallisée dans laquelle la phase cristalline ou les phases cristallines du polymère ont la même orientation cristallographique et une deuxième sous-couche dudit polymère recouverte par la première sous-couche et au contact de la première sous couche dans laquelle la phase cristalline ou les phases cristallines du polymère ont des orientations cristallographiques différentes.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
les figures 1 et 2 représentent des diagrammes de diffraction des rayons X obtenus respectivement pour des films d'un copolymère du PVDF réalisées respectivement selon un procédé de fabrication classique et selon un mode de réalisation d'un procédé de fabrication ;
la figure 3 représente des courbes d'évolution de la permittivité diélectrique relative de films d'un copolymère de PVDF, réalisés respectivement selon un procédé de fabrication classique et selon un mode de réalisation d'un procédé de fabrication, en fonction de la fréquence de la tension appliquée au film ;
la figure 4 représente des courbes d'évolution du déplacement de films d'un copolymère de PVDF, réalisés respectivement selon un procédé de fabrication classique et selon un mode de réalisation d'un procédé de fabrication, en fonction de la tension appliquée au film ;
les figures 5A à 5E sont des coupes, partielles et schématiques, des structures obtenues à des étapes successives d'un mode de réalisation d'un procédé de fabrication d'un transistor MOS comprenant un film d'un copolymère de PVDF ; et
les figures 6A à 6D sont des coupes, partielles et schématiques, des structures obtenues à des étapes successives d'un mode de réalisation d'un procédé de fabrication d'un dispositif pyroélectrique/piézoélectrique comprenant un film d'un copolymère de PVDF.

### Description détaillée

Par souci de clarté, de mêmes éléments ont été désignés par de mêmes références aux différentes figures et, de plus, comme cela est habituel dans la représentation des circuits électroniques, les diverses figures ne sont pas tracées à l'échelle. De plus, seuls les éléments utiles à la compréhension de la présente description ont été représentés et sont décrits. Sauf précision contraire, les expressions "approximativement", "sensiblement", et "de l'ordre de" signifient à 10 % près, de préférence à 5 % près.

Les inventeurs ont mis en évidence qu'en sélectionnant des copolymères du PVDF particuliers et en leur appliquant un traitement thermique particulier, il est obtenu un film de copolymère du PVDF ayant des propriétés piézoélectrique et/ou pyroélectrique importantes et/ou une constante diélectrique élevée.

Le copolymère de PVDF comprend le poly(fluorure de vinylidène - trifluoroéthylène - chlorofluoroéthylène) (P(VDF-TrFE-CFE)), le poly(fluorure de vinylidène - trifluoroéthylène - chlorotrifluoro éthylène) (P(VDF-TrFE-CTFE)) ou un mélange de ces composés. Le taux de chlore en molécules du copolymère est supérieur ou égal à 3 %, de préférence supérieur ou égal à 4 %.

Selon un mode de réalisation, le traitement thermique comprend l'application d'impulsions brèves d'un rayonnement ultraviolet (UV), ou flashs ultraviolets, sur une couche liquide comprenant en majorité le copolymère de PVDF. Ceci permet de chauffer la couche liquide pour favoriser la formation de la phase cristalline β. Ceci permet de chauffer localement la couche liquide sans chauffer le substrat sur lequel la couche comprenant le copolymère de PVDF est formée et/ou sans chauffer des composants électroniques voisins du film du copolymère de PVDF. On obtient ainsi un film du copolymère du PVDF ayant des propriétés recherchées.

Par rayonnement UV, on entend un rayonnement dont les longueurs d'onde sont, au moins en partie, comprises entre 200 nm et 400 nm. Le rayonnement UV peut être fourni par une lampe, par exemple une lampe Xénon qui peut fournir un rayonnement qui s'étend sur une plage de longueurs d'onde plus large que la plage de 200 nm à 400 nm, par exemple sur la plage de 150 nm à 1000 nm. La distance entre la source d'émission des impulsions UV et la face de la couche comprenant majoritairement le copolymère du PVDF est comprise entre 2 cm et 10 cm. Selon un mode de réalisation, la durée d'une impulsion UV est comprise entre 10 µs et 5 ms, de préférence entre 500 µs et 2 ms. La durée entre deux impulsions UV successives peut être comprise entre 1 et 5 secondes. La fluence du rayonnement (UV) peut être comprise entre 1 J/cm² et 100 J/cm², de préférence entre 10 J/cm² et 25 J/cm². Le nombre d'impulsions est compris entre 1 et 100.

Des essais ont été réalisés pour comparer les propriétés d'un film d'un copolymère de PVDF, appelé film de comparaison par la suite, obtenu par un procédé de fabrication comprenant une étape de recuit thermique par un chauffage de longue durée du film et les propriétés d'un film d'un copolymère de PVDF, appelé film test par la suite, obtenu par un procédé de fabrication comprenant une étape d'application d'impulsions UV.

Le film de comparaison et le film de test ont été obtenus chacun à partir d'une couche liquide de 2 µm d'épaisseur formée par dépôt par sérigraphie d'une solution comprenant 20 % en poids du copolymère P(VDF₆₀-TrFe_{30,3}-CTFE_{9,7}) et 80 % en poids de cyclopentanone. Le taux molaire ou taux moléculaire en chlore du P(VDF₆₀-TrFe_{30,3}-CTFE_{9,7}) est de 9,7 %. La solution a été obtenue en mélangeant 2 g de cyclopentanone et 0,4 g de poudre de P(VDF₆₀-TrFe_{30,3}-CTFE_{9,7}) à une température comprise entre 40 et 45°C pendant plusieurs heures. Pour le film de comparaison, la couche a été chauffée et déposée sur une plaque chauffante à 130°C pendant 15 minutes. Pour le film test, la couche a été irradiée par 20 impulsions UV fournies par une lampe UV ayant un rayonnement sur une plage de longueurs d'onde qui s'étend de 240 nm à 1000 nm, avec plus de 75 % de l'énergie entre 240 nm et 400 nm. La durée de chaque impulsion était de 2 ms. La durée entre deux impulsions successives était de 1 seconde. La fluence en énergie du rayonnement UV était de 21 J/cm². La distance entre la lampe UV et la face supérieure de la couche du copolymère de PVDF était de 4,5 cm.

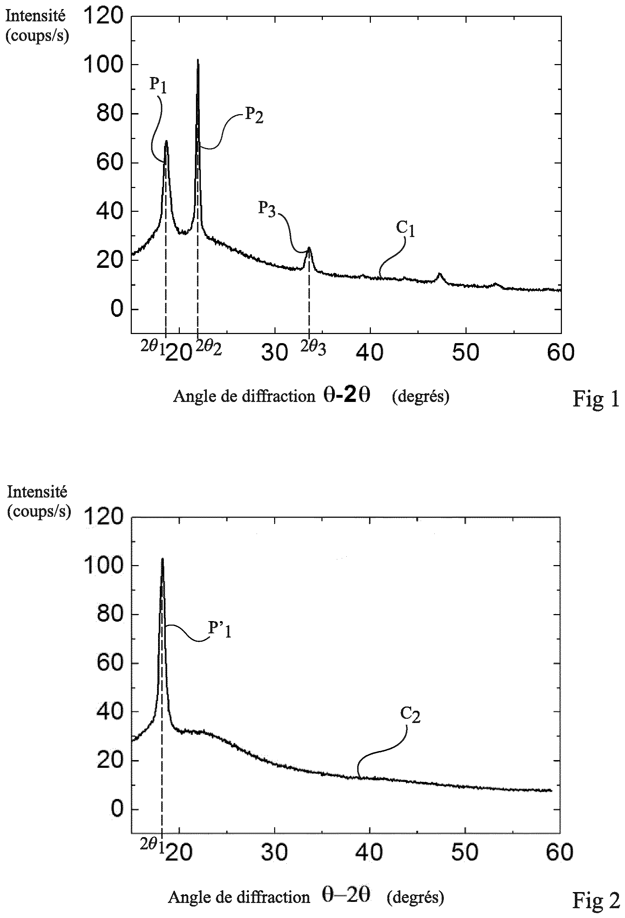

La figure 1 représente un diagramme de diffraction aux rayons X du film de comparaison. La courbe C₁ comprend plusieurs pics de cristallisation, notamment un pic P₁ pour un angle 2θ₁ sensiblement égal à 18°, un pic P₂ d'intensité plus importante pour un angle 2θ₂ sensiblement égal à 22°, un pic P₃ d'intensité réduite pour un angle 2θ₃ sensiblement égal à 34°, et des pics supplémentaires à des angles 2θ supérieurs à 2θ₃ et à des intensités inférieures. Ceci traduit la présence de phases cristallines β dans le film de comparaison ayant des orientations cristallographiques différentes.

La figure 2 représente un diagramme de diffraction aux rayons X du film test. La courbe C₂ comprend un seul pic P'₁ pour l'angle 2θ₁ sensiblement égal à 18°. Ceci traduit la présence d'une phase cristalline β dans le film test ayant une seule orientation cristallographique. Le taux de cristallinité du film de comparaison est supérieur strictement au taux de cristallinité du film test.

Les inventeurs ont mis en évidence que pour les autres copolymères du PVDF autres que les polymères du groupe comprenant le P(VDF-TrFE-CFE), le P(VDF-TrFE-CTFE) ou un mélange de ces composés, le diagramme de diffraction aux rayons X du film de test était sensiblement identique au diagramme de diffraction aux rayons X du film de test.

Les inventeurs ont mis en évidence une augmentation de la permittivité diélectrique relative εᵣ par rapport au vide, également appelée constante diélectrique, du film test par rapport au film de comparaison.

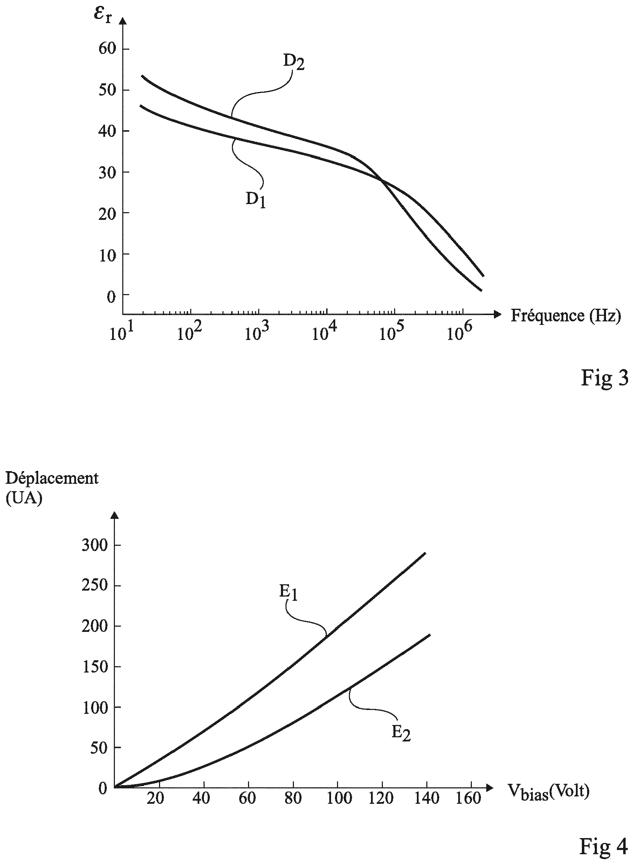

La figure 3 représente des courbes d'évolution D₁ et D₂ de la permittivité diélectrique relative εᵣ, également appelée constante diélectrique, respectivement du film de comparaison et du film de test en fonction de la fréquence. La mesure de la permittivité diélectrique relative εᵣ a été réalisée en plaçant chaque film entre deux électrodes entre lesquelles est appliquée une tension sinusoïdale. La permittivité diélectrique relative εᵣ du film test est supérieure à la permittivité diélectrique relative du film de comparaison pour des fréquences inférieures à 5.10⁴ Hz. En particulier, pour les fréquences inférieures à 100 Hz, l'augmentation de la permittivité diélectrique relative est d'au moins 15 %. Pour le P(VDF-TrFE-CTFE), la constante diélectrique à moins de 10 Hz est supérieure ou égale à 55. Pour le P(VDF-TrFE-CFE), la constante diélectrique à moins de 10 Hz est supérieure ou égale à 65.

Les inventeurs ont mis en évidence une augmentation de l'activité piézoélectrique et/ou pyroélectrique d'un film de comparaison par rapport au film de test.

La figure 4 représente des courbes d'évolution E₁ et E₂ du déplacement, exprimé en unité arbitraire, respectivement du film de comparaison et du film test en fonction de la tension appliquée au film. La mesure du déplacement a été réalisée en plaçant chaque film entre deux électrodes entre lesquelles est appliquée la tension de commande. Les inventeurs ont mis en évidence une augmentation de plus de 50 % du déplacement du film test par rapport au film de comparaison.

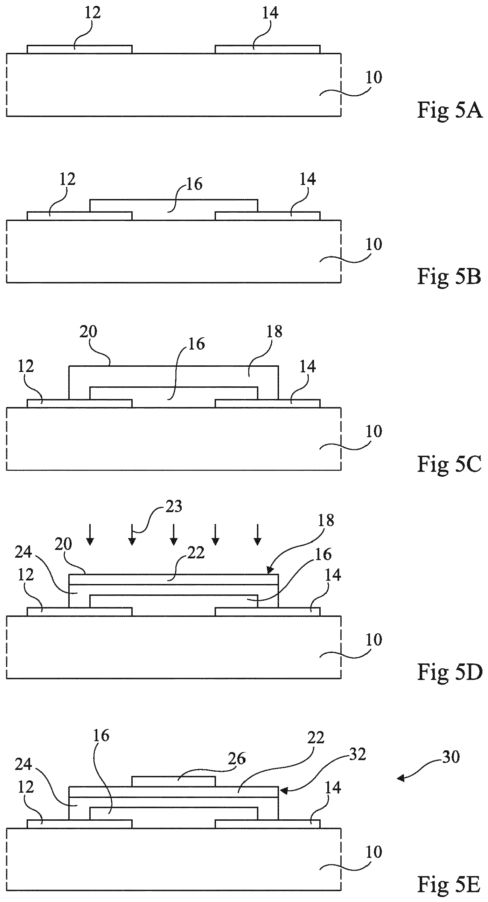

Les figures 5A à 5E illustrent un mode de réalisation d'un procédé de fabrication d'un dispositif électronique comprenant un transistor MOS dont l'isolant de grille est formé par un film d'un copolymère de PVDF.

La figure 5A est une coupe, partielle et schématique, de la structure obtenue après avoir formé, sur un substrat 10, des première et deuxième portions conductrices électriquement 12, 14.

L'épaisseur du substrat 10 peut être comprise entre 5 µm et 1000 µm. Le substrat 10 peut être un substrat rigide ou un substrat flexible. Un substrat flexible peut, sous l'action d'une force extérieure, se déformer, notamment se plier, sans se casser ou se déchirer. Un exemple de substrat rigide comprend un substrat en silicium, en germanium ou en verre. De préférence, le substrat 12 est un film flexible. Un exemple de substrat flexible comprend un film en PEN (polyéthylène naphtalate), PET (polyéthylène téréphtalate), PI (polyimide) ou PEEK (polyétheréthercétone). De préférence, le substrat 10 peut avoir une épaisseur de 10 µm à 300 µm et présenter un comportement flexible.

Chaque portion conductrice 12, 14 peut être réalisée en un matériau métallique choisi parmi le groupe comprenant l'argent, l'or, le nickel, le platine, l'aluminium, le titane, le cuivre, le tungstène et un alliage ou un mélange d'au moins deux de ces métaux, ou en un polymère conducteur, par exemple le poly(3, 4-éthylènedioxythiophène) : poly(styrène sulfonate) (PEDOT : PSS). Chaque portion conductrice 12, 14 peut avoir une épaisseur comprise entre 10 nm et 300 nm. Le dépôt des portions conductrices 12, 14 sur le substrat 10 peut être réalisé par un dépôt physique en phase vapeur ou par des techniques d'impression, notamment par sérigraphie ou par impression à jet d'encre, ou par pulvérisation.

La figure 5B représente la structure obtenue après avoir formé une portion semiconductrice 16 sur les portions conductrices 12, 14. La portion semiconductrice 16 a une épaisseur comprise entre 20 nm et 200 nm, de préférence entre 20 nm et 100 nm. La portion semiconductrice 16 peut être en un matériau organique semiconducteur. Elle peut être composée de petites molécules organiques de type N, notamment des pérylènes et leurs dérivés, de petites molécules organiques de type P, notamment des pentacènes et leurs dérivés, de polymères de type P, notamment des polythiophènes et leurs dérivés, ou de polymères de type N, notamment des vinylènes, des polymères contenant des unités azoles, des polythiophènes et leurs dérivés.

La figure 5C représente la structure obtenue après avoir déposé une portion d'une portion liquide 18, éventuellement visqueuse, sur la portion 16, et éventuellement sur une partie des portions conductrices 12, 14. La portion de couche liquide 18 comprend un solvant et un composé comprenant majoritairement un copolymère de PVDF dissous dans le solvant. L'épaisseur de la portion 18 est comprise entre 100 nm et 8 µm, de préférence entre 100 nm et 5 µm. La portion 18 comprend une face 20 du côté opposé à la portion semiconductrice 16.

Le copolymère de PVDF comprend le P(VDF-TrFE-CFE), le P(VDF-TrFE-CTFE) ou un mélange de ces composés. Le taux de chlore en molécules du copolymère est supérieur ou égal à 3 %, de préférence supérieur ou égal à 4 %.

Le composé peut, en outre, comprendre des charges. Les charges peuvent correspondre à des particules céramiques, par exemple des particules de titanate de baryum (BaPiO₃), des particules de zirconate titanate de plomb (PbZrTiO₃ ou PZT), des particules de titanate de plomb (PbTiO₃) ou des particules de tantalate de lithium (LiTaO₃). La concentration en poids de charges dans le composé par rapport à la masse du copolymère de PVDF peut varier de 5 % à 25 %.

Le composé peut donc comprendre un mélange d'au moins un copolymère de PVDF et d'au moins une céramique, par exemple les mélanges suivants : P(VDF-TrFE-CTFE)/BaTiO₃, P(VDF-TrFE-CFE)/BaTiO₃, P(VDF-TrFE-CTFE)/PbZrTiO₃, P(VDF-TrFE-CFE)/PbZrTiO₃, P(VDF-TrFE-CTFE)/PbTiO₃, P(VDF-TrFE-CFE)/PbTiO₃, P(VDF-TrFE-CTFE)/LiTaO₃ et P(VDF-TrFE-CFE)/LiTaO₃.

De préférence, le solvant est un solvant polaire. Ceci permet, de façon avantageuse, d'améliorer la dissolution du copolymère de PVDF. De préférence, le solvant est adapté à absorber, au moins partiellement, le rayonnement UV, par exemple sur une plage de longueurs d'onde comprises entre 200 nm et 400 nm. Selon un mode de réalisation, la température d'évaporation du solvant est comprise entre 110°C et 140°C, de préférence entre 110°C et 130°C, plus préférentiellement entre 120°C et 130°C. Le solvant peut être choisi parmi le groupe comprenant le cyclopentanone, le dyméthylsulphoxide (DMSO), le dyméthyl-formamide (DMF), le gamma-butyrolactone (GBL), le méthyl-éthylcétone (MEK), l'acétone, le dyméthylacétamide (DMAc) et le N-méthyl-E-pyrrolidone (NMP). De préférence, le solvant est le cyclopentanone.

La portion 18 comprend de 1 % à 30 %, de préférence de 1 % à 20 %, en poids du composé comprenant majoritairement le copolymère de PVDF et de 70 % à 99 %, de préférence de 80 % à 99 %, en poids du solvant. De façon avantageuse, la concentration en poids du solvant est choisie pour ajuster la viscosité de la solution obtenue afin de permettre la mise en oeuvre de techniques d'impression. Le procédé de formation de la portion de couche liquide 18 peut correspondre à un procédé dit additif, par exemple par impression directe de la portion 18 aux emplacements souhaités, par exemple par impression par jet d'encre, héliographie, sérigraphie, flexographie, revêtement par pulvérisation (en anglais spray coating) ou dépôt de gouttes (en anglais drop-casting). Le procédé de formation de la portion de couche liquide 18 peut correspondre à un procédé dit soustractif, dans lequel la couche liquide est déposée sur la totalité de la structure et dans lequel les portions non utilisées sont ensuite retirées, par exemple par photolithographie ou ablation laser. Selon le matériau considéré, le dépôt sur la totalité de la structure peut être réalisé par exemple par voie liquide, par pulvérisation cathodique ou par évaporation. Il peut s'agir notamment de procédés du type dépôt à la tournette, revêtement par pulvérisation, héliographie, revêtement par filière (en anglais slot-die coating), revêtement à la lame (en anglais blade-coating), flexographie ou sérigraphie.

La figure 5D illustre une étape d'irradiation d'au moins une partie de la portion 18 du côté de la face 20, ce qui entraîne la formation en surface de la portion 18 d'une couche 22 comprenant le copolymère de PVDF comprenant sensiblement des cristaux ayant la même orientation cristallographique, le reste de la portion 18 recouvert par la couche 22 n'étant sensiblement pas modifié. L'irradiation aux rayons UV est représentée de façon schématique en figure 5D par les flèches 23. L'irradiation est réalisée par une succession d'impulsions de rayonnement UV, ou flashs ultraviolets, qui ont les caractéristiques décrites précédemment. L'épaisseur finale de la couche 22 dépend notamment du nombre d'impulsions UV et de la composition de la portion 18. Selon un mode de réalisation, la totalité de la portion 18 peut être modifiée lors de l'étape d'irradiation. A titre d'exemple, pour une épaisseur de la couche 22 de 100 nm, le nombre d'impulsions UV peut varier de 1 à 2 avec une fluence entre 10 J/cm² et 15 J/cm² et pour une épaisseur de la couche 22 de l'ordre de 4 µm, le nombre d'impulsions UV peut être de l'ordre de 2 à 6 avec une fluence entre 17 J/cm² et 21 J/cm².

De façon avantageuse, le solvant de la portion de couche liquide 18 absorbe au moins en partie le rayonnement UV. Ceci permet d'améliorer le chauffage du composé à base d'UV et de favoriser la formation de la phase cristalline β. La température d'évaporation du solvant est avantageusement supérieure à 110°C pour éviter une évaporation trop rapide du solvant avant la formation de la phase cristalline β qui se produit entre 120°C et 130°C.

L'étape d'exposition de la portion 18 à des impulsions UV peut être suivie d'une étape de recuit thermique, par exemple une étape de recuit thermique sur plaque chauffante, par exemple à une température comprise entre 80°C et 120°C pendant une durée comprise entre 5 min et 30 min. Cette étape de recuit thermique sur plaque chauffante ne modifie pas la structure de la couche 22. De préférence, l'étape d'irradiation et de recuit thermique global entraînent une évaporation de plus de 50 % en poids, de préférence de plus de 80 % en poids, du solvant de la portion de la couche 18.

La figure 5E représente la structure obtenue après avoir déposé une deuxième portion conductrice 26 sur la couche 22. La portion conductrice 26 peut avoir la même composition que les portions conductrices 12, 14. La portion conductrice 26 peut avoir une épaisseur comprise entre 10 nm et 300 nm. Le dépôt de la portion conductrice 26 peut être réalisé par un dépôt physique en phase vapeur ou par des techniques d'impression, notamment par sérigraphie ou par impression à jet d'encre, ou par pulvérisation. Une étape de recuit peut alors être prévue, par exemple par irradiation de la portion conductrice 26 par impulsions UV ayant une fluence comprise entre 15 J/cm² et 25 J/cm².

Un transistor MOS 30 est alors obtenu. La portion conductrice 26 forme la grille du transistor 30. L'empilement des couches isolantes 22 et 24 forme l'isolant de grille 32 du transistor 30. Les portions conductrices 12 et 14 forment les contacts de drain et de source du transistor 30. Le canal du transistor 30 est formé dans la couche semiconductrice 16.

Le diagramme de diffraction aux rayons X de la couche 22 est analogue à la courbe C₂ représentée en figure 2. Le diagramme de diffraction aux rayons X de la couche 24 est analogue à la courbe C₁ représenté en figure 1. La constante diélectrique de l'isolant de grille du transistor MOS 30 est donc augmentée au contact de la grille 26. Ceci permet, de façon avantageuse, d'augmenter le courant de drain du transistor MOS 30 à l'état passant. Les inventeurs ont, en outre, mis en évidence que les courants de fuite du transistor MOS sont réduits.

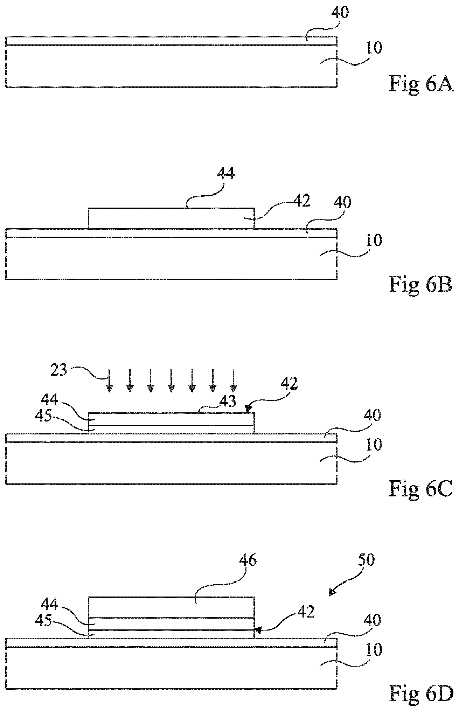

Les figures 6A à 6D illustrent un mode de réalisation d'un procédé de fabrication d'un composant électronique ayant la structure d'un condensateur de type métal-oxyde-métal, également appelé condensateur MIM, et pouvant être utilisé notamment comme capteur ou comme actionneur.

La figure 6A représente la structure obtenue après la formation d'une portion conductrice 40 sur le substrat 10. La formation de la portion conductrice 40 peut être réalisée comme cela a été décrit précédemment pour la formation des portions conductrices 12, 14 en relation avec la figure 5A.

La figure 6B représente la structure obtenue après la formation, sur la portion conductrice 40, d'une portion 42 liquide, éventuellement visqueuse. La portion de couche liquide 42 comprend un solvant et un composé comprenant majoritairement un copolymère de PVDF dissous dans le solvant. La composition de la portion 42 et le procédé de dépôt de la portion 42 peuvent correspondre à ce qui a été décrit précédemment pour la portion 18 en relation avec la figure 5C. On désigne la face de la portion 42 opposée à la portion conductrice 40 par la référence 43.

La figure 6C représente la structure obtenue après l'irradiation de la portion 42 du côté de la face 43. Le procédé d'irradiation de la portion 42 peut correspondre à ce qui a été décrit précédemment pour l'irradiation de la portion 18 en relation avec la figure 5D. Il entraîne la formation d'une couche 44 analogue à la couche 22 représentée en figure 5D, dont la structure cristalline est modifiée par l'irradiation, en surface de la portion 42. Un recuit global de la couche 42 peut être ensuite prévu pour former une couche 45 analogue à la couche 24 représentée en figure 5D.

La figure 6D représente la structure obtenue après la formation d'une portion conductrice 46 sur le substrat 10. La formation de la portion conductrice 46 peut être réalisée comme cela a été décrit précédemment pour la formation de la portion conductrice 26 en relation avec la figure 5E.

Un composant électronique 50 ayant la structure d'un condensateur MIM est alors obtenu. Les portions conductrices 40 et 46 forment les électrodes du composant électronique. Le diagramme de diffraction aux rayons X de la couche 44 est analogue à la courbe C₂ représenté en figure 2. Pour certains composants électroniques, notamment pour un condensateur, il peut être souhaitable que toute la portion 42 soit modifiée lors de l'étape d'irradiation. Dans ce cas, l'étape de recuit thermique global de la portion 42 n'est pas présente et la durée totale du procédé de fabrication du composant électronique peut être réduite. Pour la réalisation d'un capteur piézoélectrique comprenant les couches 44 et 45, il peut être souhaitable que la couche 44 soit située du côté de l'électrode 46 utilisée pour réaliser des mesures.

Des modes de réalisation particuliers ont été décrits. Diverses variantes et modifications apparaîtront à l'homme de l'art.

## Revendications

1. Procédé de fabrication d'un dispositif électronique (30 ; 50) comprenant un film (32 ; 42) comprenant les étapes suivantes :
former au moins d'une couche (18 ; 42) d'une solution comprenant un solvant et un composé comprenant un polymère choisi parmi le groupe comprenant le poly(fluorure de vinylidène - trifluoroéthylène - chlorofluoroéthylène) (P(VDF-TrFE-CFE)), le poly(fluorure de vinylidène - trifluoroéthylène - chlorotrifluoro éthylène) (P(VDF-TrFE-CTFE)) et un mélange de ces composés, le taux de chlore en molécules du copolymère étant supérieur ou égal à 3 % ; et
irradier au moins la couche avec des impulsions d'au moins un rayonnement ultraviolet.

2. Procédé selon la revendication 1, dans lequel le rayonnement ultraviolet est émis par une source, dans lequel ladite couche (18 ; 42) comprend une face (20 ; 44) exposée au rayonnement ultraviolet et dans lequel la distance entre ladite face et la source est comprise entre 2 cm et 10 cm.

3. Procédé selon la revendication 1 ou 2, dans lequel la durée de chaque impulsion est comprise entre 500 µs et 2 ms.

4. Procédé selon l'une quelconque des revendications 1 à 3, dans lequel la fluence en énergie du rayonnement ultraviolet est comprise entre 10 J/cm² et 25 J/cm².

5. Procédé selon l'une quelconque des revendications 1 à 4, dans lequel seule une partie de la couche (18) est chauffée au cours de l'étape d'irradiation.

6. Procédé selon la revendication 5, dans lequel l'étape d'irradiation est suivie d'une étape de recuit thermique du reste de la couche (18) à une température comprise entre 80°C et 120°C.

7. Procédé selon l'une quelconque des revendications 1 à 6, dans lequel le solvant a une température d'évaporation comprise entre 110°C et 140°C.

8. Procédé selon l'une quelconque des revendications 1 à 7, dans lequel la solution comprend de 80 % à 95 % en poids du solvant et de 5 % à 20 % en poids du composé.

9. Dispositif piézoélectrique et/ou pyroélectrique comprenant une couche (32 ; 42) comprenant en majorité un polymère en partie cristallisé choisi parmi le groupe comprenant le poly(fluorure de vinylidène - trifluoroéthylène - chlorofluoroéthylène) (P(VDF-TrFE-CFE)), le poly(fluorure de vinylidène - trifluoroéthylène - chlorotrifluoro éthylène) (P(VDF-TrFE-CTFE)) et un mélange de ces composés, le taux de chlore en molécules du copolymère étant supérieur ou égal à 3 %, dans lequel sur au moins une partie de l'épaisseur de la couche, la phase cristalline ou les phases cristallines du polymère ont la même orientation cristallographique.

10. Dispositif selon la revendication 9, dans lequel la couche (32) comprend une première sous-couche (22) dudit polymère cristallisée dans laquelle la phase cristalline ou les phases cristallines du polymère ont la même orientation cristallographique et une deuxième sous-couche (24) dudit polymère recouverte par la première sous-couche et au contact de la première sous couche dans laquelle la phase cristalline ou les phases cristallines du polymère ont des orientations cristallographiques différentes.
